# EUROPEAN PATENT APPLICATION

(11) **EP 4 852 632 A1**
(43) Date of publication of application: **09.12.2026**
(21) Application number: 25181186.5
(22) Date of filing: 05.06.2025
(51) Int. Cl.: H05K 7/20

(54) **COMMUNICATION DEVICE**

(71) Applicant: Valeo Comfort and Driving Assistance, 94000 Créteil (FR)
(72) Inventor: TREBES, Andreas, 94000 Créteil (FR)
(74) Representative: Delaval, Guillaume Laurent

(57) **Abstract**

A communication device comprises a printed circuit board (4), an antenna (10; 12), a communication module (6; 8) and a metal chassis (2) including a planar portion (20).

The printed circuit board (4) has a first face (42) and a second face (44) opposite to the first face (42). The communication module (6; 8) is mounted on the first face (42) of the printed circuit board (4).

The antenna (10; 12) is mounted on the second face (44) of the printed circuit board (4). The communication module (6; 8) is located between the printed circuit board (4) and the planar portion (20) of the metal chassis (2).

The metal chassis (2) includes at least one protrusion (26; 28; 30; 32) protruding from the planar portion (20) towards the printed circuit board (4) and participating in establishing a physical connection between the printed circuit board (4) and the planar portion (20) of the metal chassis (2).

## Description

### TECHNICAL FIELD OF THE INVENTION

The invention relates to the technical field of telecommunications.

More precisely the invention relates to a communication device.

### BACKGROUND INFORMATION AND PRIOR ART

Communication devices used in vehicles to exchange electromagnetic signals with external electronic devices generally include a printed circuit board carrying an antenna and a communication module, and mounted in a metal chassis.

In addition to its basic structural function, the metal chassis can participate in electromagnetic shielding and/or cooling (in particular to evacuate heat generated by the communication module).

### SUMMARY OF THE INVENTION

In this context, a communication device is provided, that comprises a printed circuit board, an antenna, a communication module and a metal chassis including a planar portion, the printed circuit board having a first face and a second face opposite to the first face and the communication module being mounted on the first face of the printed circuit board, the antenna being mounted on the second face of the printed circuit board, the communication module being located between the printed circuit board and the planar portion of the metal chassis, the metal chassis including at least one protrusion protruding from the planar portion towards the printed circuit board and participating in establishing a physical connection between the printed circuit board and the planar portion of the metal chassis.

Such a construction is particularly interesting as the communication module and the antenna are located on respective sides of the printed circuit board (which is required in some situations), while the physical connection between the printed circuit board and the metal chassis (provided at least in part by the protrusion) makes it possible to use the metal chassis for various purposes linked with the printed circuit board, such as heat evacuation or electromagnetic shielding.

Such a construction is adapted for a communication device to be mounted in the roof of a vehicle (the antenna then being located above the printed circuit board), for instance.

According to possible optional features:
- a thermally conductive material is interposed between said protrusion and the first face of the printed circuit board;
- a thermally conductive layer is deposited on the first face of the printed circuit board between the communication module and the thermally conductive material (in contact with the thermally conductive material and with the communication module or a via extending between the communication module and the printed circuit board);
- a thermally conductive material is interposed between the communication module and the planar portion of the metal chassis;
- the thermally conductive material is a thermal paste;
- the planar portion has an extra thickness in a region facing the communication module;
- the communication device comprises at least one via extending between the communication module and the printed circuit board;
- an electrically conductive material is interposed between said protrusion and the first face of the printed circuit board;
- the metal chassis includes at least two protrusions including said at least one protrusion and protruding towards the printed circuit board;
- the communication module is located between said two protrusions;
- electrically conductive material is interposed between the first face of the printed circuit board and each one of the two protrusions;
- the planar portion has an inner face facing the printed circuit board and an outer face opposite the inner face and provided with ribs.

### DETAILED DESCRIPTION OF EXAMPLE(S)

The following description with reference to the accompanying drawing will make it clear what the invention consists of and how it can be achieved. The invention is not limited to the embodiments illustrated in the drawing. Accordingly, it should be understood that where features mentioned in the claims are followed by reference signs, such signs are included solely for the purpose of enhancing the intelligibility of the claims and are in no way limiting on the scope of the claims.

In the accompanying drawing:

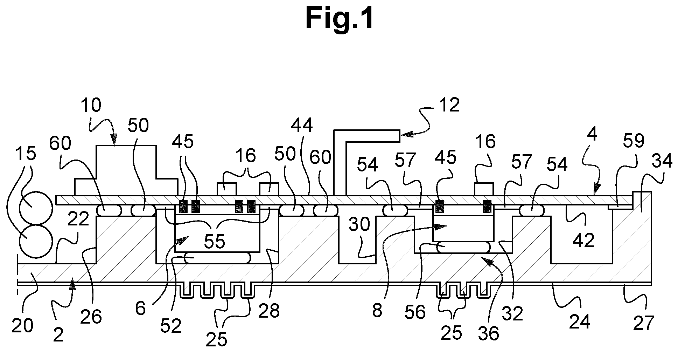

- Figure 1 shows a communication device according to a possible embodiment of the invention.

The communication device of Figure 1 includes a metal chassis 2 and a printed circuit board 4.

The printed circuit board 4 has a first face 42 facing the metal chassis 2 and a second face 44 opposite the first face 42 (the second face 44 thus being directed away from the chassis 2).

The communication device includes at least one communication module, here a first communication module 6 and a second communication module 8.

In the example described, the first communication module 6 is a Network Access Device (NAD). The first communication module 6 is thus configured to establish a wireless communication with a base station of a telecommunication network.

In the example described, the second communication module 8 is a WiFi module. The second communication module 8 is thus configured to participate in, or establish, a local area network.

Each of the first and second communication modules 6, 8 includes a daughterboard, electronic circuitry carried by the daughterboard and configured to perform the sought functionalities, and a metal box carried by the daughterboard and defining (together with the daughterboard) an enclosure enclosing the electronic circuitry.

Each of the first and second communication modules 6, 8 is mounted on the first face 42 of the printed circuit board 4. Precisely, for each of the first and second communication modules 6, 8, the daughterboard of the concerned communication module 6; 8 is affixed (*e.g.* by soldering) to the first face 42 of the printed circuit board 4.

As further explained below, at least one thermal via 45 is provided (*i.e.* extends) between at least one communication module 6; 8 and the printed circuit board 4. Precisely, such a thermal via 45 (or thermal vias) extends both in the daughterboard of the concerned communication module 6; 8 and in the printed circuit board 4.

The communication device also includes at least one antenna, here a plurality of antennas 10, 12, mounted on the second face 44 of the printed circuit board 4.

The antennas include for instance a GNSS-antenna 10 (*i.e.* an antenna configured to receive satellite signals) and/or a cell antenna 12 (*i.e.* an antenna to receive electromagnetic signals from the above-mentioned base station of the telecommunication network and/or transmit electromagnetic signals to this base station).

The communication device of Figure 1 is adapted to be mounted in a vehicle (e.g. an automotive vehicle), for instance in the roof of the vehicle. In other embodiments, the communication device could however also be used in other contexts.

At least one of these antennas 10, 12 may be connected (via circuits of the printed circuit board 4) to one of the communication modules 6, 8 (to be used as a receiving antenna and/or a transmitting antenna by the concerned communication module). For instance, in the present case, the cell antenna 12 is connected (via some of the circuits of the printed circuit board 4) to the first communication module 6.

The second face 44 of the printed circuit board 4 may also carry components 16 of other electronic circuits, such as *e.g.* a decoupling circuit. This decoupling circuit may be connected for instance to a power supply of the communication device or to one of the antennas 10, 12 mentioned above. The components 16 mentioned above include for instance at least one capacitor.

The communication device also includes at least one battery 15 (here two such batteries) to power the electric circuits of the communication device, including the communication modules 6,8. For this purpose, said at least one battery 15 may be connected to the power supply mentioned above.

The metal chassis 2 includes a planar portion 20, which defines the lateral extension of the metal chassis 2. The planar portion 20 includes an inner face 22 facing the printed circuit board 4 and an outer face 24 opposite the inner face 22 (and therefore directed towards the outside of the communication device).

The metal chassis 2 also includes protrusions, here in the form of chimneys 26, 28, 30, 32, protruding from the planar portion 20 towards the printed circuit board 4.

As visible in Figure 1, the first communication module 6 is located between two of these protrusions (or chimneys) 26, 28, in a space formed between these two protrusions 26, 28 and/or between the planar portion 20 and the printed circuit board 4.

A thermal paste 50 and/or a gasket 60 of electrically conductive material (*e.g*. electrically conductive foam) are deposited on the top surface of at least one protrusion 26; 28 (here on the top surface of each protrusion 26; 28) such that this thermal paste 50 and/or this gasket 60 are each interposed between the concerned protrusion 26; 28 and the (first face 42 of) the printed circuit board 4, being here in contact with the concerned protrusion 26; 28 and the (first face 42 of) the printed circuit board 4.

The thermal paste 50 is a thermally conductive material (having *e.g.* a thermal conductivity between 1 W/(m.K) and 10 W/(m.k)) such that heat generated by the first communication module 6 and transferred to the printed circuit board 4 can be evacuated via the thermal paste 50 and the concerned protrusion 26; 28 (which is a portion of the metal chassis 2 and thus made of metal).

Precisely, in the example described here, heat generated by the first communication module 6 is transferred to the printed circuit board 4 via thermal vias 45 (extending between the daughterboard of the first communication module 6 and the printed circuit board 4) and from the printed circuit board 4 to the concerned protrusion 26; 28 via the thermal paste 50 so as to be evacuated through the metal chassis 2.

In addition, in the embodiment described here, the printed circuit board 4 includes a thermally conductive layer 55 deposited on the first face 42 of the printed circuit board 4 between the first communication module 6 and the thermal paste 50. This thermally conductive layer 55 (for instance a metal layer) is here a tin layer, having e.g. a thickness between 0,2 mm and 0,7 mm.

This thermally conductive layer 55 is in contact with the thermal paste 50 and with the first communication module 6 and/or at least one thermal via 45 extending between the first communication module 6 and the printed circuit board 4.

In the example shown in Figure 1, the thermally conductive layer 55 is in contact with the thermal paste 50 but does not extend on the printed circuit board 4 at the level of the thermal paste 50. According to a possible variation, the thermally conductive layer 55 may extend on the printed circuit board 4 above at least part of the thermal paste 50 such that at least part of the thermal paste 50 extends between the thermally conductive layer 55 and the concerned protrusion 26; 28.

In the present example, thermal paste 52 (forming a thermally conductive material) is also deposited between the first communication module 6 and the (inner face 22 of) the planar portion 20 (the thermal paste 52 being here in contact with the first communication module 6 and the planar portion 20) so as to create another way for heat transfer between the first communication module 6 and the metal chassis 2.

The gasket 60 of electrically conductive material is in contact with the concerned protrusion 26; 28 and the printed circuit board 4, which makes it possible (using for instance a conductive track formed on the printed circuit board 4, connected to ground and positioned in contact with the gasket 60) to ground the concerned protrusion 26; 28 and therefore create an electromagnetic shielding for the first communication module 6.

In the example shown in Figure 1, the first communication module 6 is located as already mentioned between two protrusions 26; 28, which may each be grounded via the concerned gasket 60. This provides a particularly efficient electromagnetic shielding of the first communication module 6.

The second communication module 8 is located between two other protrusions (or chimneys) 30, 32, in a space formed between these two protrusions 30, 32 and/or between the planar portion 20 and the printed circuit board 4.

A thermal paste 54 is deposited on the top surface of at least one protrusion 30; 32 (here on the top surface of each protrusion 30; 32) such that this thermal paste 54 is interposed between the concerned protrusion 30; 32 and the (first face 42 of) the printed circuit board 4, being here in contact with the concerned protrusion 30; 32 and the (first face 42 of) the printed circuit board 4.

The thermal paste 54 is a thermally conductive material such that heat generated by the second communication module 8 and transferred to the printed circuit board 4 can be evacuated via the thermal paste 54 and the concerned protrusion 30; 32.

Precisely, in the example described here, heat generated by the second communication module 8 is transferred to the printed circuit board 4 via thermal vias 45 (extending between the daughterboard of the second communication module 8 and the printed circuit board 4) and from the printed circuit board 4 to the concerned protrusion 30; 32 via the thermal paste 54 so as to be evacuated through the metal chassis 2.

In addition, as described above for the first communication module 6, the printed circuit board 4 includes a thermally conductive layer 57 deposited on the first face 42 of the printed circuit board 4 between the second communication module 8 and the thermal paste 54. This thermally conductive layer 57 (for instance a metal layer) is here a tin layer, having *e.g.* a thickness between 0,2 mm and 0,7 mm.

This thermally conductive layer 55 is in contact with the thermal paste 50 and with the first communication module 6 and/or at least one thermal via 45 extending between the first communication module 6 and the printed circuit board 4.

In the example shown in Figure 1, the thermally conductive layer 55 is in contact with the thermal paste 50 but does not extend on the printed circuit board 4 at the level of the thermal paste 50. According to a possible variation, the thermally conductive layer 55 may extend on the printed circuit board 4 above at least part of the thermal paste 50 such that at least part of the thermal paste 50 extends between the thermally conductive layer 55 and the concerned protrusion 26; 28.

As the second communication module 8 has a reduced thickness (compared for instance to the first communication module 6), the planar portion 20 has an extra thickness in a region (or area) 36 facing the second communication module 8.

Thermal paste 56 (forming a thermally conductive material) is deposited between the second communication module 8 and extra thickness region 36 (the thermal paste 56 being here in contact with the second communication module 8 and the extra thickness region 36) so as to create another way for heat transfer between the second communication module 8 and the metal chassis 2. The extra thickness of region 36 makes it possible to reduce the quantity of thermal paste needed to fill in the gap between the metal chassis 2 and the second communication module 8.

In order to improve heat evacuation, the outer face 24 of the metal chassis 2 is provided with (thermal) ribs 25.

In addition, in order to improve the electromagnetic properties of the communication device (its ε_{R} value in particular), the outer face 24 is covered with an oxidation layer or an organic coating 27 (*e.g.* deposited by painting).

As shown in Figure 1, the metal chassis also includes a wall 34 in (physical and thus electrical) contact with a conductive track 59 carried by the printed circuit board 4 so as to ground the metal chassis 2 also via this conductive track 59 and improve the electromagnetic shielding effect.

In the embodiment just described, thermally conductive material is interposed between each protrusion and the printed circuit board. However, the invention is not limited to embodiments with such a thermally conductive material; in some embodiments, only an electrically conductive material may be interposed between the protrusion(s) and the printed circuit board.

## Claims

1. Communication device comprising a printed circuit board (4), an antenna (10; 12), a communication module (6; 8) and a metal chassis (2) including a planar portion (20),
wherein the printed circuit board (4) has a first face (42) and a second face (44) opposite to the first face (42) and wherein the communication module (6; 8) is mounted on the first face (42) of the printed circuit board (4),
**characterised in that** the antenna (10; 12) is mounted on the second face (44) of the printed circuit board (4), **in that** the communication module (6; 8) is located between the printed circuit board (4) and the planar portion (20) of the metal chassis (2), and **in that** the metal chassis (2) includes at least one protrusion (26; 28; 30; 32) protruding from the planar portion (20) towards the printed circuit board (4) and participating in establishing a physical connection between the printed circuit board (4) and the planar portion (20) of the metal chassis (2).

2. Communication device according to claim 1, wherein a thermally conductive material (50; 54) is interposed between said protrusion (26; 28; 30; 32) and the first face (42) of the printed circuit board (4).

3. Communication device according to claim 2, wherein a thermally conductive layer (55; 57) is deposited on the first face (42) of the printed circuit board (4) between the communication module (6; 8) and the thermally conductive material (50; 54).

4. Communication device according to any of claims 1-3, wherein a thermally conductive material (52; 56) is interposed between the communication module (6; 8) and the planar portion (20) of the metal chassis (2).

5. Communication device according to any of claims 2-4, wherein the thermally conductive material (50; 52; 54; 56) is a thermal paste.

6. Communication device according to any of claims 1-5, wherein the planar portion (20) has an extra thickness in a region (36) facing the communication module (8).

7. Communication device according to any of claims 1-6, comprising at least one via (45) extending between the communication module (6; 8) and the printed circuit board (4).

8. Communication device according to any of claims 1-7, wherein an electrically conductive material (60) is interposed between said protrusion (26; 28; 30; 32) and the first face (42) of the printed circuit board (4).

9. Communication device according to any of claims 1-7, wherein the metal chassis (2) includes at least two protrusions (26, 28; 30, 32) including said at least one protrusion and protruding towards the printed circuit board (4), and wherein the communication module (6; 8) is located between said two protrusions (26, 28; 30, 32).

10. Communication device according to claim 9, wherein electrically conductive material (60) is interposed between the first face (42) of the printed circuit board (4) and each one of the two protrusions (26, 28).

11. Communication device according to any of claims 1-10, wherein the planar portion (20) has an inner face (22) facing the printed circuit board (4) and an outer face (24) opposite the inner face (22) and provided with ribs (25).
